# FASCICULE DE BREVET EUROPEEN

(11) **EP 0 901 158 B1**
(45) Date de publication et mention de la délivrance du brevet: **14.06.2006**
(21) Numéro de dépôt: 98402090.9
(22) Date de dépôt: 21.08.1998
(51) Int. Cl.: H01L 21/20, H01L 21/762, H01L 27/06

(54) **Circuit intégré de puissance, procédé de fabrication d'un tel circuit et convertisseur incluant un tel circuit**
Integrierte Leistungsschaltung, Verfahren zu desser Herstellung, und Umformer mit solch einer Schaltung
Smart power integrated circuit, method for its manufacturing and converter comprising such a circuit

(30) Priorité: 25.08.1997 FR 9710625
(43) Date de publication de la demande: 10.03.1999
(73) Titulaire: Alstom Transport S.A., 75116 Paris (FR)
(72) Inventeur: Petitbon, Alain, 78730 St Arnoult En Yvelines (FR); Ranchy, Eric, 92140 Clamart (FR)
(74) Mandataire: Blot, Philippe Robert Emile

(56) Documents cités:
- EP-A- 0 707 338
- WO-A-91/11822
- WO-A-94/15359
- US-A- 5 186 785
- KIKUCHI H ET AL: "PARTIALLY BONDED SOI SUBSTRATES FOR INTELLIGENT POWER ICS" INTERNATIONAL CONFERENCE ON SOLID STATE DEVICES AND MATERIALS,21 août 1995, pages 848-850, XP000544768
- POLO M C ET AL: "Growth of diamond by laser ablation of graphite" DIAMOND AND RELATED MATERIALS, vol. 5-6, no. 4, 1 mai 1995, page 780-783 XP004066828
- ELLIS P J ET AL: "Some effects of silicon substrate roughness on the growth of highly oriented ?100 ? diamond films" DIAMOND AND RELATED MATERIALS, vol. 4, no. 4, 15 avril 1995, page 406-409 XP004066727
- EL-KAREH B ET AL: "SILICON ON INSULATOR - AN EMERGING HIGH-LEVERAGE TECHNOLOGY" IEEE TRANSACTIONS ON COMPONENTS, PACKAGING AND MANUFACTURING TECHNOLOGY: PART A, vol. 18, no. 1, mars 1995, pages 187-194, XP000493568

## Description

La présente invention concerne un circuit intégré de puissance, du type comprenant une couche de substrat en matériau semi-conducteur, une couche active en matériau semi-conducteur dopé, qui forme plusieurs composants portés à des potentiels différents, ainsi qu'une couche isolante permettant d'isoler électriquement ces composants.

Il est connu, dans le domaine de l'électronique de puissance, d'intégrer différents composants au sein d'un même module électronique de puissance. Un circuit intégré de ce genre comprend alors des composants électroniques de puissance, des circuits de commande, des circuits de protection ainsi que des circuits d'interface avec des micro-processeurs réalisés à partir de transistors et de diodes. Une telle intégration entraîne une réduction des connexions, ce qui induit une diminution des inductances parasites et une limitation des problèmes de compatibilité électromagnétique, de sorte que la vitesse de traitement est notablement accrue.

Il est toutefois nécessaire d'isoler électriquement les uns par rapport aux autres les composants de ce genre de circuits intégrés, qui fonctionnent à des tensions très différentes les uns des autres.

A cet effet, il est connu d'intercaler, entre la couche substrat et la couche active dopée, une couche isolante réalisée en silice.

Différents procédés de préparation de circuits intégrés incluant une telle couche de silice, sont décrits dans la publication "Silicon-On-Insulator-An Emerging High-Leverage Technology", part A, vol. 18, NE 1, mars 1995 de la revue IEEE.

Selon ces procédés, la couche d'oxyde enterrée est réalisée soit par implantation d'oxygène dans une tranche de silicium, soit par liaison à haute température entre deux tranches de silicium dont l'une a été préalablement oxydée, soit par dépôt sur une tranche de silicium oxydée d'un film de silicium amorphe ou poly-cristallin, qui est recristallisé par fusion de zone.

Quel que soit leur mode d'obtention, les circuits intégrés de puissance comprenant une couche isolante enterrée en silice présentent certains inconvénients. Ils possèdent en effet une tenue en tension limitée à environ 500 volts, de sorte que des composants fonctionnant à une tension supérieure ne peuvent être intégrés sur le même circuit que des composants fonctionnant à basse tension, ce qui entraînerait la destruction de ces derniers.

Cette limitation est particulièrement critique dans le domaine du transport par traction électrique, où les tensions rencontrées sont généralement très élevées.

Un autre problème réside dans la faible conductibilité thermique de la silice qui peut conduire à des échauffements du semi-conducteur qui sont préjudiciable à son intégrité.

Le document WO-A-9 111 822 décrit un circuit intégré de puissance du type comprenant une couche de substrat en matériau semi-conducteur, une couche active en matériau semi-conducteur dopé, ladite couche active formant plusieurs composants, et une couche isolante comportant du carbone sous forme de diamant et permettant d'isoler électriquement lesdits composants de la couche de substrat, dans lequel ladite couche isolante recouvre complètement la couche de substrat et se trouve en contact avec une couche de silice.

Le document EP-A-0 707 338 décrit un procédé de fabrication d'un circuit intégré du type comprenant une couche de substrat en matériau semi-conducteur, une couche active en matériau semi-conducteur dopé, ladite couche active formant plusieurs composants, et une couche isolante permettant d'isoler électriquement lesdits composants de la couche de substrat, comprenant les étapes suivantes de :
disposition de la couche de substrat dans une enceinte à vide,
mise sous vide de ladite enceinte,
réalisation d'une couche isolante, et
réalisation sur ladite couche isolante d'une couche supérieure semi-conductrice, de
manière à constituer des composants,
la réalisation de ladite couche isolante comprenant les étapes :
d'introduction dans ladite enceinte d'un gaz renfermant du carbone, et
de chauffage de ladite couche de substrat à une température comprise entre 750°C et 900°C de manière à revêtir la couche de substrat d'une couche isolante comportant du carbone sous forme de diamant, dans lequel la couche isolante est réalisé sur toute la couche de substrat et se trouve en contact avec une couche de silice.

L'invention se propose de réaliser un circuit intégré dont la couche isolante permet d'isoler électriquement des composants qui sont portés à des potentiels différents.

A cet effet, l'invention a pour objet un circuit intégré de puissance selon la revendication 1 et un procédé de fabrication d'un circuit intégré de puissance selon la revendication 5.

Des caractéristiques avantageuses sont indiquées dans les revendication dépendantes.

L'invention a enfin pour objet un convertisseur pour véhicule à alimentation électrique, destiné à être placé entre une source d'alimentation et un moteur électrique dudit véhicule, caractérisé en ce qu'il comprend au moins un circuit intégré de puissance tel que décrit ci-dessus.

L'invention va être décrite ci-dessous, en référence aux dessins annexés, donnés uniquement à titre d'exemple et dans lesquels :
- les figures 1A, 1B et 1C sont trois vues schématiques illustrant des phases successives d'un premier mode de fabrication d'un circuit intégré conforme à l'invention ;
- les figures 2A, 2B et 2C sont des vues analogues aux figures 1A à 1C, illustrant des phases successives d'un second mode de fabrication d'un circuit intégré conforme à l'invention ;
- la figure 3 est une vue schématique à plus grande échelle d'un circuit intégré conforme à l'invention, incluant des composants fonctionnant à des tensions respectivement très élevées et faibles.

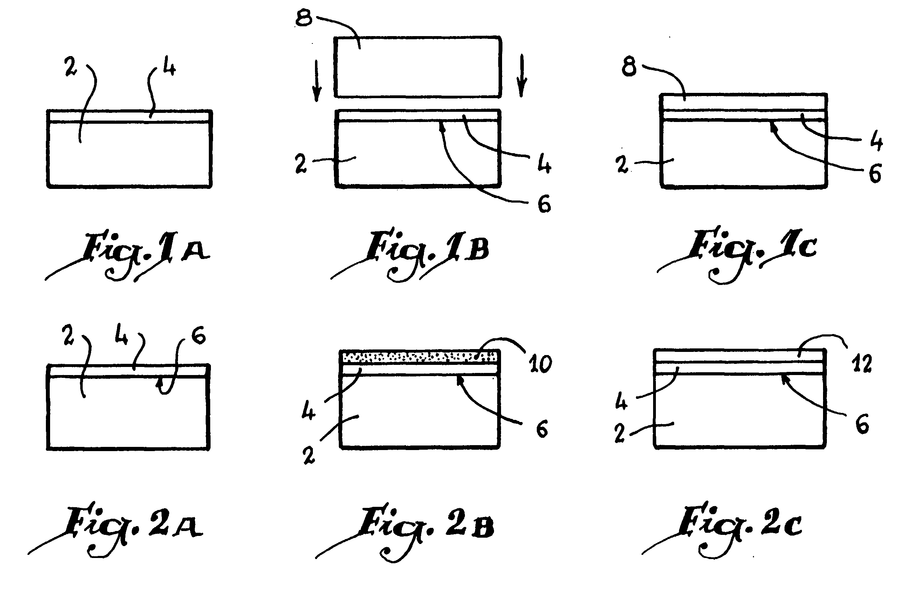

La figure 1A représente une plaquette mince de silicium mono-cristallin non dopé. Cette plaquette 2 présente une épaisseur d'environ 200 µm et une surface de l'ordre d'un cm². Cette plaquette 2 est revêtue par un procédé de dépôt chimique en phase de vapeur, encore dénommé procédé CVD.

A cet effet, la plaquette est introduite dans une chambre non représentée susceptible d'être mise sous vide. La chambre est évacuée de sorte qu'il y règne une pression de 0.08 à 0.8 mbar et on y introduit un gaz contenant du carbone, tel que du méthane dilué à 1% volumique dans l'hydrogène. Puis on produit une décharge électrique entre la plaquette 2 à revêtir et une partie de la chambre ce qui permet de décomposer l'hydrogène gazeux en hydrogène atomique. On pourrait également prévoir d'utiliser un plasma ou une flamme. De plus, on élève par tout moyen approprié, la température de la plaquette jusqu'à environ 600 à 1000°C. La plaquette 2 est soumise à ces conditions pendant une durée d'environ dix minutes de sorte qu'il se forme sur sa surface une couche 4 composée de carbone dans laquelle une proportion très élevée des liaisons entre atomes de carbone est du type des liaisons des atomes de carbone dans le diamant.

Il se forme, à l'interface entre la couche 4 et la plaquette 2 de silicium, une mince couche de carbure de silicium 6 qui assure une excellente tenue mécanique de la couche 4 sur la plaquette 2 et n'est pas préjudiciable au bon fonctionnement du circuit, car son épaisseur est très faible.

La durée du traitement de revêtement est réglée pour obtenir une couche 4 isolante comportant du carbone sous forme de diamant d'une épaisseur souhaitable, c'est-à-dire supérieure à environ 10 µm.

Comme le montre la figure 1B, une plaquette supplémentaire 8 en silicium monocristallin est rapportée sur la face supérieure libre de la couche 4. Ces différentes couches superposées sont ensuite recuites sous vide à une température d'environ 1000°C, de manière à augmenter les forces de liaison existant entre la couche 4 et la plaquette 8. Il importe toutefois de ne pas effectuer cette opération à une température supérieure à 1000°C, afin d'empêcher la transformation du diamant contenu dans la couche 4 en graphite.

La plaquette supplémentaire 8 liée par sa surface inférieure à la couche isolante 4, est ensuite amincie jusqu'à l'épaisseur désirée par exemple conformément au procédé mécanique décrit dans le journal Appl. Phys. Lett., vol. 48, NE.1, 1986, p. 78.

La plaquette supplémentaire 8 subit alors une opération classique de dopage, de manière à y réaliser des composants habituels de circuits intégrés.

Les figures 2A à 2C illustrent les phases successives d'un autre procédé de fabrication d'un circuit intégré conforme à l'invention. Des plaquettes de silicium 2 sont tout d'abord recouvertes d'une couche 4 isolante, de manière analogue à ce qui a été décrit en faisant référence à la figure 1A.

Comme l'illustre la figure 2B, une couche 10 de silicium amorphe ou poly-cristallin est déposée sur la face supérieure de la couche isolante 4, par dépôt chimique en phase vapeur. A cet effet, on introduit, de manière classique, dans la chambre sous vide un précurseur gazeux du silicium, tel du silane, que l'on chauffe à environ 600°C en absence d'oxygène.

La couche 10 est ensuite soumise à une recristallisation par fusion de zones de sorte que le silicium amorphe ou poly-cristallin dont elle est composée se transforme de manière à réaliser une couche 12 en silicium mono-cristallin susceptible d'être dopé. Cette opération de recristallisation par fusion de zone est par exemple illustrée dans l'article "Role of impurities in zone melting recristallization of 10 m High poly-cristalline silicone film" J.APPL.PHYS., vol. 63, NE 8, PP. 2660-2668, 1988. La couche 12 de solicium monocristallin est ensuite dopée, de manière analogue à ce qui a été décrit ci-dessus.

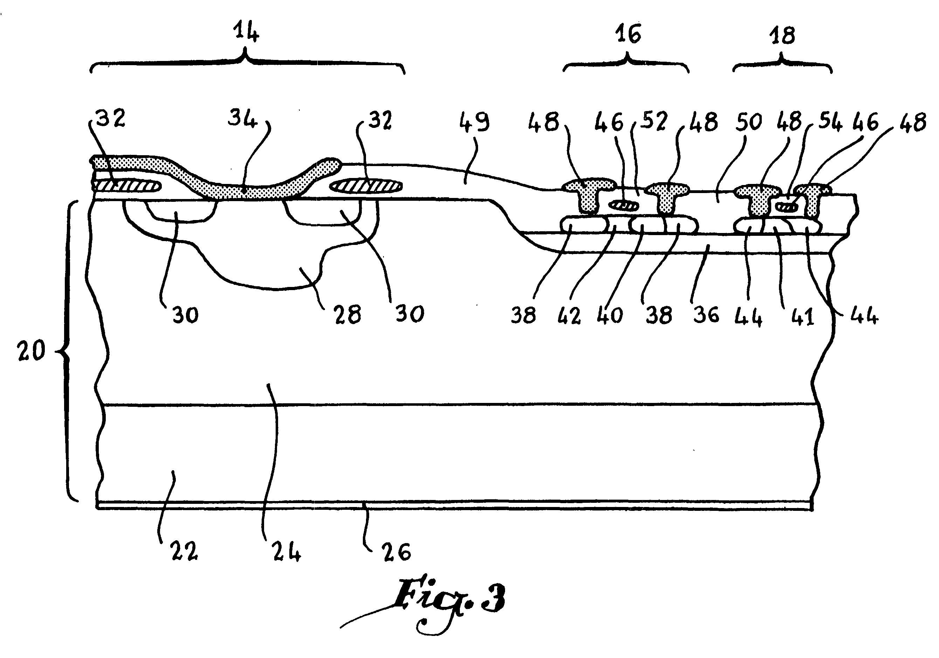

La figure 3 montre un circuit intégré conforme à l'invention, regroupant des composants fonctionnant à des tensions très différentes.

Ce circuit comprend un transistor 14 vertical type IGBT, fonctionnant à une très haute tension supérieure à 1000 volts et un circuit CMOS fonctionnant à une tension voisine de 15 volts, et constitué d'un transistor NMOS 16 et d'un transistor PMOS 18.

L'IGBT 14 est réalisé de manière connue, à partir d'un substrat 20 dopé de manière à former des couches 22 et 24 respectivement P+ et N-, substrat sous lequel est rapporté un collecteur 26.

Le substrat comprend des zones supérieures dopées 28, 30 de plus faibles dimensions transversales, respectivement P+ et N+. L'IGBT est complété par des grilles 32 ainsi qu'un émetteur 34 réalisés de manière connue. La tension entre l'émetteur 34 et le collecteur 26 est supérieure à 1 000 volts.

Les deux transistors MOS sont formés à partir des couches 22 et 24 du substrat. Toutefois, contrairement à l'IGBT, une couche 36 comportant du carbone sous forme de diamant est disposée sur la face supérieure de la couche N-24. Cette couche 36 a été réalisée par un procédé de dépôt chimique en phase vapeur conforme à celui décrit en référence à la figure 1A, et présente par exemple une épaisseur régulière de 10 µm.

Sur la face supérieure de cette couche 36 a été déposée une couche de silicium amorphe ou poly-cristallin, qui a été rendu mono-cristallin au moyen d'un procédé de recristallisation par fusion de zone. Ce silicium mono-cristallin a ensuite été dopé, de manière connue, de manière à réaliser des zones dopées respectivement N+ 38, N- 40, N 41, P- 42 et P+ 44. Deux grilles 46 et quatre émetteurs 48 ont ensuite été disposés au-dessus de ces zones dopées 38, 40, 42, 44 de manière à former le premier transistor NMOS 16 et le second transistor PMOS 18.

La couche composée de diamant ne s'étend pas sur toute la surface du substrat 20, du fait de la structure verticale de l'IGBT.

En outre, les grilles 32 de l'IGBT sont recouvertes d'une couche isolante 49 supplémentaire qui permet l'isolation mutuelle des grilles et de l'émetteur. Toutefois, cette couche supplémentaire est réalisée en un oxyde tel que de la silice, car la tension entre les grilles et l'émetteur, inférieure à celle régnant entre le collecteur et l'émetteur, est admissible par ce type de matériau.

La couche 49 se prolonge par une couche 50 prévue à la jonction entre les deux transistors MOS 16, 18, ainsi que par des couches supplémentaires analogues 52, 54 prévues au voisinage de chaque grille 46 des transistors 16, 18. Ces couches 50, 52, 54 présentent une tenue en tension suffisante dans la mesure où les transistors 16, 18 sont isolés de l'IGBT par la couche 36.

L'exemple comparatif ci-dessous démontre les performances supérieures d'une couche isolante renfermant du diamant, conformément à l'invention, par rapport à une couche isolante en silice.

### EXEMPLE COMPARATIF

Un premier circuit intégré de type classique comporte une couche de substrat composée de silicium mono-cristallin, une couche isolante en silice d'une épaisseur de 400 à 500 nm et une couche supérieure de silicium mono-cristallin dopé de 250 nm d'épaisseur de manière à réaliser un ou plusieurs IGBT et/ou un ou plusieurs MOS.

Un second circuit intégré, conforme à l'invention, comporte une couche de substrat et une couche supérieure analogue à celle du premier circuit ci-dessus, ainsi qu'une couche isolante comportant du carbone sous forme de diamant, d'une épaisseur de 10 µm. Ce second circuit intégré a été réalisé conformément au procédé décrit en faisant référence aux figures 1A à 1C.

On impose aux deux circuits une tension d'environ 200 volts. La conductibilité thermique du diamant, qui est de 1500 W/m.K, est bien supérieure à celle de la silice qui n'est que de 1,5 W/m.K., de sorte que la couche isolante du second circuit est nettement mieux à même d'évacuer la chaleur générée lors du fonctionnement de ce dernier, que la couche isolante du premier circuit. La couche isolante conforme à l'invention permet donc de réduire de manière significative les échauffements que subit le circuit intégré.

On impose ensuite aux deux circuits une tension voisine de 1 000 volts. Etant donné que la tension de claquage du diamant est de 100 kV/mm, alors que celle de la silice n'est que de 10 kV/mm, seule la couche isolante du second circuit continue à assumer sa fonction d'isolation électrique.

L'exemple comparatif ci-dessus démontre clairement les avantages de la couche conforme à l'invention, en comparaison avec la couche isolante en silice.

En effet, aux gammes de tension pour lesquelles les deux couches assurent une fonction d'isolement électrique, la couche conforme à l'invention garantit une bien meilleure évacuation de la chaleur, ce qui permet de préserver l'intégrité du circuit.

En outre, la couche conforme à l'invention continue à assurer cette fonction d'isolation électrique, à des tensions très élevées pour lesquelles la couche en silice n'est plus isolante.

La couche conforme à l'invention conserve cette fonction isolante jusqu'à des tensions extrêmement élevées, dans la mesure où son épaisseur peut être aisément accrue en augmentant la durée du traitement chimique en phase vapeur. Ceci n'est pas possible dans le cas d'une couche en silice, car cette dernière est formée soit par implantation ionique, soit par oxydation du silicium, ce qui limite son épaisseur à moins de 1 µm.

Il est ainsi possible d'envisager, pour une durée de traitement d'environ dix minutes, l'obtention d'une couche comportant du carbone sous forme de diamant d'une épaisseur d'environ 10 µm, qui posséderait ainsi une tenue en tension d'environ 1 500 volts.

La couche conforme à l'invention présente en outre une excellente tenue mécanique due à la présence de carbure de silicium se formant, lors du dépôt chimique en phase vapeur, à l'interface de la couche de silicium et la couche comportant du carbone sous forme de diamant.

La couche conforme à l'invention trouve tout particulièrement son application à l'électronique de puissance de véhicules à alimentation électrique, pour lesquels les tensions utilisées sont nettement supérieures aux tensions admises par la couche de silice. Il demeure alors possible d'intégrer, grâce à la couche conforme à l'invention, tout type de composants sur un même circuit intégré, ce que ne permet pas la couche de silice.

## Revendications

1. Circuit intégré de puissance du type comprenant une couche de substrat (2;20) en matériau semi-conducteur, une couche active (8;12;28;30;36,38,40,42,44) en matériau semi-conducteur dopé, ladite couche active formant plusieurs composants (14;16,18) succeptibles d'être portés à des potentiels différents, et une couche isolante (6;36) comportant du carbone sous forme de diamant et permettant d'isoler électriquement lesdits composants,
dans lequel ladite couche isolante ne recouvre que partiellement la couche de substrat (2;20) et se trouve en contact avec une couche (49;50) renfermant un oxyde, notamment de la silice.

2. Circuit intégré selon la revendication 1, **caractérisé en ce que** ladite couche isolante en spectrographie RAMAN, possède un pic à une longueur d'onde de 1332 cm⁻¹ dont la largeur à mi-hauteur est inférieure à 5 cm⁻¹ et, de préférence, inférieure à 3 cm⁻¹.

3. Circuit intégré selon la revendication 1 ou 2, **caractérisé en ce que** ladite couche isolante présente une épaisseur supérieure à 1 µm, de manière préférée une épaisseur supérieure à 5 µm et, de manière encore préférée, une épaisseur supérieure à 10µm.

4. Circuit intégré selon l'une quelconque des revendications 1 à 3, **caractérisé en ce qu'**au moins une partie (22,24) de la couche de substrat est réalisée en matériau semi-conducteur dopé.

5. Procédé de fabrication d'un circuit intégré de puissance du type comprenant une couche de substrat en matériau semi-conducteur, une couche active en matériau semi-conducteur dopé, ladite couche active formant plusieurs composants susceptibles d'être portés à des potentiels différents, et une couche isolante permettant d'isoler électriquement lesdits composants, comprenant les étapes suivantes de :
- disposition de la couche de substrat dans une enceinte à vide,
- mise sous vide de ladite enceinte,
- réalisation d'une couche isolante, et
- réalisation sur ladite couche isolante d'une couche supérieure semi-conductrice, de manière à constituer des composants susceptibles d'être portés à des tensions différentes entre eux,
la réalisation de ladite couche isolante comprenant les étapes :
- d'introduction dans ladite enceinte d'un gaz renfermant du carbone, et
- de chauffage de ladite couche de substrat à une température comprise entre 600°C et 1000°C de manière à revêtir la couche de substrat d'une couche isolante comportant du carbone sous forme de diamant, dans lequel circuit intégré la couche isolante n'est réalisée que sur une partie de la couche de substrat et se trouve en contact avec une couche renfermant un oxyde, notamment de la silice.

6. Procédé selon la revendication 5, **caractérisé en ce que** l'étape de réalisation sur la couche comportant du carbone sous forme de diamant, d'une couche supérieure semi-conductrice, comprend une étape de disposition, sur la face libre de la couche comportant du carbone sous forme de diamant, d'une plaquette monocristalline, une étape de recuit de cet ensemble à une température comprise entre 800°C et 1000°C, et une étape de dopage de ladite plaquette mononcristalline.

7. Procédé selon la revendication 5, **caractérisé en ce que** l'étape de réalisation sur la couche comportant du carbone sous forme de diamant, d'une couche supérieure semi-conductrice, comprend une étape de dépôt, sur ladite couche comportant du carbone sous forme de diamant, d'une couche amorphe ou polycristalline, une étape de recristallisation par fusion de zone de manière à transformer ladite couche amomrphe ou polycristalline en couche monocristalline et une étape de dopage de ladite couche monocristalline.

8. Convertisseur pour véhicule à alimentation électrique, destiné à être placé entre une source d'alimentation et un moteur électrique du véhicule, **caractérisé en ce qu'**il comprend au moins un circuit intégré conforme à l'une quelconque des revendications 1 à 4.

## Claims

1. Integrated power circuit of the type comprising a substrate layer (2; 20) of semi-conductor material, an active layer (8; 12; 28; 30; 36, 38, 40, 42, 44) of doped semi-conductor material, said active layer forming a plurality of components (14; 16, 18) capable of being brought to different potentials, and an insulating layer (6; 36) comprising carbon in the form of diamond and allowing said components to be insulated electrically, in which integrated circuit said insulating layer covers the substrate layer (2; 20) only partially and is in contact with a layer (49; 50) comprising an oxide, especially silicon dioxide.

2. Integrated circuit according to claim 1, **characterised in that** in RAMAN spectroscopy said insulating layer has a peak at a wavelength of 1332 cm⁻¹, the width at half height of which is less than 5 cm⁻¹ and preferably less than 3 cm⁻¹.

3. Integrated circuit according to claim 1 or 2, **characterised in that** said insulating layer has a thickness greater than 1 µm, preferably a thickness greater than 5 µm and more preferably a thickness greater than 10 µm.

4. Integrated circuit according to any one of claims 1 to 3, **characterised in that** at least a portion (22, 24) of the substrate layer is made of doped semi-conductor material.

5. Process for the manufacture of an integrated power circuit of the type comprising a substrate layer of semi-conductor material, an active layer of doped semi-conductor material, said active layer forming a plurality of components capable of being brought to different potentials, and an insulating layer allowing said components to be insulated electrically, which process comprises the following steps:
- disposing the substrate layer in a vacuum chamber,
- placing said chamber under vacuum,
- producing an insulating layer and
- producing on said insulating layer an upper semi-conductor layer, in such a manner as to constitute components capable of being brought to different potentials,
the production of said insulating layer comprising the following steps:
- introducing a carbon-containing gas into said chamber, and
- heating said substrate layer to a temperature between 600°C and 1000°C in order to cover the substrate layer with an insulating layer comprising carbon in the form of diamond, in which integrated circuit the insulating layer is produced over only a portion of the substrate layer and is in contact with a layer comprising an oxide, especially silicon dioxide.

6. Process according to claim 5, **characterised in that** the step of producing an upper semi-conductor layer on the layer comprising carbon in the form of diamond comprises a step of arranging a monocrystalline wafer on the free face of the layer comprising carbon in the form of diamond, a step of annealing that assembly at a temperature between 800°C and 1000°C, and a step of doping said monocrystalline wafer.

7. Process according to claim 5, **characterised in that** the step of producing an upper semi-conductor layer on the layer comprising carbon in the form of diamond comprises a step of depositing an amorphous or polycrystalline layer on said layer comprising carbon in the form of diamond, a step of recrystallisation by zone melting in order to convert said amorphous or polycrystalline layer into a monocrystalline layer, and a step of doping said monocrystalline layer.

8. Converter for an electrically powered vehicle, which converter is to be placed between a power source and an electric motor of the vehicle, **characterised in that** it comprises at least one integrated circuit according to any one of claims 1 to 4.

## Patentansprüche

1. Integrierte Leistungsschaltung der Bauart, die eine Substratschicht (2; 20) aus Halbleitermaterial, eine aktive Schicht (8; 12; 28; 30; 36, 38, 40, 42, 44) aus dotiertem Halbleitermaterial, wobei die aktive Schicht mehrere Bauteile (14; 16, 18) bildet, die sich auf verschiedene Potentiale bringen lassen, und eine Isolierschicht (6; 36) aufweist, die Kohlenstoff in Diamantform aufweist und es ermöglicht, die Bauteile elektrisch zu isolieren,
wobei die Isolierschicht die Substratschicht (2; 20) nur teilweise bedeckt und sich in Kontakt mit einer Schicht (49; 50) befindet, in die ein Oxid, insbesondere Siliziumoxid, eingeschlossen ist.

2. Integrierte Schaltung nach Anspruch 1,
**dadurch gekennzeichnet, dass**
die Isolierschicht in der RAMAN-Spektrografie einen Peak mit einer Wellenlänge von 1332 cm⁻¹ besitzt, deren Breite auf halber Höhe unter 5 cm⁻¹ und vorzugsweise unter 3 cm⁻¹ liegt.

3. Integrierte Schaltung nach Anspruch 1 oder 2,
**dadurch gekennzeichnet, dass**
die Isolierschicht eine Dicke von mehr als 1 µm, vorzugsweise eine Dicke von mehr als 5 µm, und noch bevorzugter eine Dicke von mehr als 10 µm aufweist.

4. Integrierte Schaltung nach einem der Ansprüche 1 bis 3,
**dadurch gekennzeichnet, dass**
mindestens ein Teil (22, 24) der Substratschicht aus einem dotierten Halbleitermaterial hergestellt ist.

5. Herstellungsverfahren für eine integrierte Leistungsschaltung der Bauart, die eine Substratschicht aus Halbleitermaterial, eine aktive Schicht aus dotiertem Halbleitermaterial, wobei die aktive Schicht mehrere Bauteile bildet, die sich auf verschiedene Potentiale bringen lassen, und eine Isolierschicht aufweist, die es ermöglicht, die Bauteile elektrisch zu isolieren, und das die folgenden Schritte umfasst:
- Anordnen der Substratschicht in einem Vakuumbehälter,
- Herstellen eines Vakuums im Behälter,
- Ausbilden einer Isolierschicht, und
- Ausbilden einer über der Isolierschicht liegenden Halbleiterschicht, um Bauteile zu bilden, die sich untereinander auf verschiedene Spannungen bringen lassen,
wobei das Ausbilden der Isolierschicht die Schritte umfasst:
- Einleiten eines kohlenstoffhaltigen Gases in den Behälter, und
- Erwärmen der Substratschicht auf eine Temperatur zwischen 600°C und 1000°C, um die Substratschicht mit einer Isolierschicht zu überziehen, die Kohlenstoff in Diamantform aufweist, wobei in der integrierten Schaltung die Isolierschicht nur auf einem Teil der Substratschicht ausgebildet wird und sich in Kontakt mit einer Schicht befindet, in die ein Oxid, insbesondere Siliziumoxid, eingeschlossen ist.

6. Verfahren nach Anspruch 5,
**dadurch gekennzeichnet, dass**
der Schritt des Ausbildens einer über der Kohlenstoff in Diamantform aufweisenden Schicht liegenden Halbleiterschicht einen Schritt des Anordnens eines monokristallinen Plättchens auf der freien Fläche der Kohlensstoff in Diamantform aufweisenden Schicht, einen Schritt des Härtens dieser Einheit bei einer Temperatur zwischen 800°C und 1000°C, und einen Schritt des Dotierens des monokristallinen Plättchens umfasst.

7. Verfahren nach Anspruch 5,
**dadurch gekennzeichnet, dass**
der Schritt des Ausbildens einer über der Kohlensstoff in Diamantform aufweisenden Schicht liegenden Halbleiterschicht einen Schritt des Abscheidens einer amorphen oder polykristallinen Schicht auf der Kohlenstoff in Diamantform aufweisenden Schicht, einen Schritt der Rekristallisation durch Zonenschmelzverfahren, um die amorphe oder polykristalline Schicht zu einer monokristallinen Schicht umzuwandeln, und einen Schritt des Dotierens der monokristallinen Schicht umfasst.

8. Elektrisch gespeister Wandler für Kraftfahrzeuge, der dazu bestimmt ist, zwischen einer Spannungsquelle und einem Elektromotor des Fahrzeugs eingesetzt zu werden,
**dadurch gekennzeichnet, dass**
er mindestens eine integrierte Schaltung nach einem der Ansprüche 1 bis 4 umfasst.
